# EUROPÄISCHE PATENTSCHRIFT

(11) **EP 2 229 732 B1**
(45) Veröffentlichungstag und Bekanntmachung des Hinweises auf die Patenterteilung: **28.11.2012**
(21) Anmeldenummer: 08863089.2
(22) Anmeldetag: 12.12.2008
(51) Int. Cl.: H03K 17/955

(54) **VORRICHTUNG UND VERFAHREN ZUM ERFASSEN EINER ANNÄHERUNG ODER BERÜHRUNG**
DEVICE AND METHOD FOR DETECTING AN APPROACH OR CONTACT
DISPOSITIF ET PROCÉDÉ DE DÉTECTION DE PROXIMITÉ OU DE CONTACT

(30) Priorität: 14.12.2007 DE 102007062263
(43) Veröffentlichungstag der Anmeldung: 22.09.2010
(73) Patentinhaber: Prettl Home Appliance Solutions GmbH, 16816 Neuruppin (DE)
(72) Erfinder: GENSCHOW, Dieter, 10627 Berlin (DE)
(74) Vertreter: Witte, Weller & Partner
(86) Internationale Anmeldenummer: PCT/EP2008/010618
(87) Internationale Veröffentlichungsnummer: WO 2009/077141

(56) Entgegenhaltungen:
- GB-A- 2 114 751
- JP-A- 58 085 637
- US-A1- 2007 124 632

## Beschreibung

Die Erfindung betrifft eine Vorrichtung und ein Verfahren zum Erfassen einer Annäherung oder Berührung bezogen auf mindestens ein Sensorelement, insbesondere für die Bedienung eines elektrischen Geräts. Außerdem betrifft die Erfindung eine Reihenschaltung von mindestens zwei derartigen Vorrichtungen.

Die Bestimmung einer Annäherung oder Berührung bezogen auf mindestens ein Sensorelement ist für die Bedienung und/oder die Überwachung eines elektrischen Geräts von großem Interesse. Dabei sind unter anderem auch solche Vorrichtungen von Interesse, die eine Positionsbestimmung bezogen auf tastenähnliche Bereiche auf einer geschlossenen Oberfläche ermöglichen. So war es in der Vergangenheit bei Bedienanordnungen üblich, die einzelnen Bedienelemente als diskrete mechanische oder elektromechanische Schalter auszuführen. Für eine Betätigung dieser Schalter mussten üblicherweise Öffnungen in einer Blende vorgesehen werden, wodurch ein Eindringen von Schmutz und Flüssigkeiten in die Bedienanordnung möglich ist. Zwar konnten die Schalter zusätzlich mit einer gummierten Schicht überzogen werden, doch war eine solche Schicht nur begrenzt haltbar und in ihrer Haptik unbefriedigend.

Um die Annäherung eines Objekts oder die Berührung auch bei einer geschlossenen Oberfläche zu detektieren, ist häufig auf elektrische Verfahren zurückgegriffen worden. Dies ist darin begründet, dass bei einem Objekt in der Regel, insbesondere bei einem menschlichen Finger, resistive und/oder kapazitive Änderungen erfasst werden können, aus denen sich die Position des Objekts bestimmen lässt. Dabei ist vielfach auf das Prinzip von kapazitiven Berührungsschaltern zurückgegriffen worden.

Das Prinzip von kapazitiven Berührungsschaltern ist schon lange bekannt. Zur Realisierung von Bedienflächen von Glaskeramik-Kochfeldern ist es beispielsweise aus der DE 80 33 570 U1 bekannt, an der oberen Oberfläche eine große Kondensatorfläche vorzusehen und an der Rückseite der Glaskeramik-Platte zwei kleinere Kondensatorflächen. In eine kleinere Kondensatorfläche wird ein Wechselstrom eingespeist. Aus der anderen kleinen Kondensatorfläche wird ein Wechselstrom entnommen. Durch einen an der Bedienseite angeordneten Finger wird die kapazitive Anordnung verstimmt, was von einer geeigneten Auswerteelektronik ausgewertet und als "Betätigung" des kapazitiven Berührungsschalters erkannt werden kann.

Aus dem Dokument EP 1 416 636 A2 ist eine weitere Ausführungsform eines kapazitiven Berührungsschalters bekannt, bei dem ein Schaumstoffkörper elektrisch leitfähige Bereiche mit einer Sensorelementoberfläche und isolierende Bereiche aufweist, die in Richtung der Erstreckung einer Glaskeramik-Platte abwechselnd vorgesehen sind. So entsteht eine Art "Strangmaterial", aus dem nebeneinander liegende kapazitive Berührungsschalter hergestellt werden können.

Es ist ferner aus der EP 0 859 467 B1 bekannt, einen kapazitiven Berührungsschalter mit einer Sensortaste bereitzustellen, die einen Pol eines Kondensators bildet, wobei die Sensortaste aus einem flexiblen, räumlich ausgedehnten, raumformveränderlichen und elektrisch leitfähigen Material besteht, das auf eine Platine aufgebracht ist und den Abstand zwischen einer Abdeckplatte und der Platine überbrückt, wobei eine Druckspannung aufrechterhalten wird.

Aus dem Dokument DE 10 2004 038 872 A1 ist ferner ein Berührungsschalter für eine Bedieneinrichtung eines Elektrogerätes wie beispielsweise eines Kochfeldes bekannt. Der Schalter weist ein Sensorelement mit zwei Sensorflächen auf, die jeweils eine oder mehrere dreieckige Teilflächen aufweisen. Die Sensorflächen werden mit Ansteuersignalen angesteuert und erfahren bei Berührung mit einem Finger eine Auskopplung entsprechend einem Teil der überdeckten Fläche. Die restliche Signalstärke wird in einem Mikrocontroller miteinander verglichen, um den Ort der Berührung als Funktion des Verhältnisses der restlichen Signalstärken und überdeckten Flächen zueinander zu ermitteln.

US 2007/0124632 A1 zeigt eine Vorrichtung zum Erkennen einer Berührung, die Vorrichtung mit einem Sensor, einem Flip-Flop und einem Mikrocontroller. Der Sensor wird mit einem Eingang des Flip-Flops zum Empfangen von elektrischen Signalen von einem Objekt verbunden, das den Sensor berührt. Der Mikrocontroller stellt zwei AC-Signale an zwei Ausgängen den zwei Eingängen des Flip-Flops zur Verfügung. Das Flip-Flop gibt ein Ausgangssignal einer ersten Art aus, wenn der Sensor nicht berührt wird. Wenn eine Berührung stattfindet, empfängt der Sensor elektrische Signale von einem Objekt und verzögert das AC-Signal, das zu dem Eingang des Flip-Flops geführt wird, an dem der Sensor angeschlossen ist. Die Verzögerung des AC-Signals, das in das Flip-Flop geführt werden soll, führt ferner dazu, dass das Flip-Flop ein Ausgangssignal einer zweiten Art ausgibt. Der Mikrocontroller stellt die Änderung des Signals fest und erkennt so die Berührung.

Vor diesem Hintergrund ist es eine Aufgabe der Erfindung, eine verbesserte Vorrichtung zum Erfassen einer Annäherung oder Berührung bezogen auf mindestens ein Sensorelement, insbesondere für die Bedienung eines elektrischen Geräts, anzugeben, die kostengünstig und effizient auch in großen Stückzahlen hergestellt werden kann. Insbesondere soll die Verwendung mehrerer Vorrichtungen leicht realisierbar sein. Ferner soll ein verbessertes entsprechendes Verfahren zum Erfassen einer Annäherung oder Berührung bezogen auf mindestens ein Sensorelement und eine entsprechende Reihenschaltung angegeben werden.

Diese Aufgabe wird nach einem Aspekt der Erfindung durch eine Vorrichtung zum Erfassen einer Annäherung oder Berührung bezogen auf mindestens ein Sensorelement gelöst, mit einer Eingangsseite und einer Ausgangsseite, zwischen denen ein erster Signalpfad mit einem ersten Eingang und einem ersten Ausgang, und ein zweiter Signalpfad mit einem zweiten Eingang und einem zweiten Ausgang angeordnet sind, wobei der erste Signalpfad eine Verzögerungseinrichtung mit einer Verzögerung aufweist, die dafür ausgebildet ist, ein erstes Eingangssignal am ersten Eingang zu einem ersten Ausgangssignal am ersten Ausgang zu verzögern, wobei die Verzögerung von der Annäherung oder Berührung bezogen auf das Sensorelement abhängig ist, und wobei der zweite Signalpfad ein Zwischenelement aufweist, das dafür ausgebildet ist, ein zweites Ausgangssignal am zweiten Ausgang zu ändern, wenn sich das von der Verzögerungseinrichtung ausgegebene erste Ausgangssignal ändert.

Diese Aufgabe wird nach einem weiteren Aspekt der Erfindung durch eine Reihenschaltung mit mindestens einer ersten und einer zweiten Vorrichtung der zuvor genannten Art gelöst, wobei die Ausgangsseite der ersten Vorrichtung mit der Eingangsseite der zweiten Vorrichtung verbunden ist, insbesondere der erste Ausgang der ersten Vorrichtung mit dem ersten Eingang der zweiten Vorrichtung, und der zweite Ausgang der ersten Vorrichtung mit dem zweiten Eingang der zweiten Vorrichtung.

Diese Aufgabe wird schließlich nach einem weiteren Aspekt der Erfindung durch ein Verfahren zum Erfassen einer Annäherung oder Berührung bezogen auf mindestens ein Sensorelement gelöst, mit den folgenden Schritten:
- Bereitstellen einer Vorrichtung mit einem ersten Eingang, einem ersten Ausgang, einem zweiten Eingang und einem zweiten Ausgang,
- Anlegen eines ersten Eingangssignals an den ersten Eingang,
- Anlegen eines zweiten Eingangssignals an den zweiten Eingang, wobei sich am zweiten Ausgang ein zweites Ausgangssignal ergibt,
- Verzögern des ersten Eingangssignals zu einem ersten Ausgangssignal, das zum ersten Ausgang geführt wird, wobei die Verzögerung von der Annäherung oder Berührung bezogen auf das Sensorelement abhängig ist,
- Verändern des zweiten Ausgangssignals, wenn sich das erste Ausgangssignal ändert, und
- Auswerten des zweiten Ausgangssignals am zweiten Ausgang.

Die Erfindung verfolgt den Ansatz, die Annäherung bzw. die Berührung bezogen auf das Sensorelement so zu repräsentieren, dass eine Auswertung und Weiterverarbeitung möglichst einfach erfolgen kann. Dabei ist es ein Gedanke der Erfindung, ein erstes Eingangssignal entlang eines ersten Signalpfads zu senden und ein zweites Eingangssignal entlang eines zweiten Signalpfads zu senden. Es sei darauf hingewiesen, dass es sich bei dem ersten und zweiten Eingangssignal sowohl um gleiche Signale handeln kann, oder um Signale, die von einer gemeinsamen Quelle abgeleitet werden, oder um Signale, wobei das eine Signal von dem anderen Signal abgeleitet ist, oder aber um Signale handeln kann, die nicht voneinander abhängig sind. Die Erfindung bietet sogar die Möglichkeit, den zweiten Eingang mit einem festen Potential zu verbinden, insbesondere Masse oder Versorgungsspannung, z.B. +5 V, so dass dann das feste Potential als zweites Eingangssignal anliegt.

Zwar ist es bevorzugt, dass die Signale in einer definierten Abhängigkeit zueinander stehen, insbesondere gleichzeitig gesendet werden, doch wird aus den nachfolgenden Erläuterungen klar werden, dass sich die Erfindung mit einer Vielzahl von verschiedenen Signalkonstellationen realisieren lässt. Ferner sei darauf hingewiesen, dass, obwohl eine Verwendung digitaler Signale bevorzugt ist und nachfolgend in den Mittelpunkt dieser Anmeldung gerückt wird, sich die Erfindung grundsätzlich auch mit analogen Signalen realisieren lässt.

Der erste Signalpfad weist die genannte Verzögerungseinrichtung auf, die ein erstes Eingangssignal am ersten Eingang zu einem ersten Ausgangssignal verzögert, das an den ersten Ausgang geleitet wird. Dadurch wirkt sich eine Änderung des ersten Eingangssignals am ersten Eingang zeitverzögert auf den ersten Ausgang aus. Die Verzögerung wird dabei in einer Größenordnung gewählt, die sich einerseits messtechnisch gut erfassen lässt und andererseits eine gute Unterscheidbarkeit verschiedener Annäherungen ermöglicht. Die Verzögerung liegt bevorzugt im Bereich zwischen 0,1 µs und 1 s, besonders bevorzugt zwischen 0,5 µs und 50 ms, und insbesondere zwischen 1 µs und 1 ms.

Der zweite Signalpfad kann das zweite Eingangssignal am zweiten Eingang unmittelbar als zweites Ausgangssignal an den zweiten Ausgang weiterleiten. Anders als im ersten Signalpfad entsteht dabei keine nennenswerte Verzögerung. Mittels des Zwischenelements im zweiten Signalpfad wird bewirkt, dass sich das zweite Ausgangssignal verändert, wenn sich das erste Ausgangssignal ändert. Mit anderen Worten ändert sich das zweite Ausgangssignal, nachdem das erste Eingangssignal von der Verzögerungseinrichtung verzögert als erstes Ausgangssignal ausgegeben wird.

Dadurch ermöglicht die Erfindung die folgende Funktionsweise. Wenn der erste Eingang und der zweite Eingang mit den entsprechenden Eingangssignalen beaufschlagt werden, erhält man am zweiten Ausgang ein Referenzsignal, welches anzeigt, dass der Verzögerungseinrichtung ein Signal zugeführt wird. Sobald dieses Signal die Verzögerungseinrichtung durchlaufen hat, wird das zweite Ausgangssignal verändert, insbesondere invertiert, so dass sich am zweiten Ausgang die Zeit erkennen lässt, zu der das erste Eingangssignal von der Verzögerungseinrichtung als zweites Ausgangssignal ausgegeben wurde. Anhand der am zweiten Ausgang ermittelten Zeiten kann so die durch die Verzögerungseinrichtung bewirkte Verzögerung bestimmt und eine Information bezüglich der Annäherung oder der Berührung bezogen auf das Sensorelement ermittelt werden. Die Abhängigkeit zwischen der Verzögerung und der Annäherung wird dabei bevorzugt derart gewählt, dass sich eine zunehmende Annäherung in einer zunehmenden Verzögerung bzw. eine abnehmende Annäherung in einer abnehmenden Verzögerung zeigt. Ferner ist es bevorzugt, dass sich eine Berührung durch eine nochmals erhöhte Verzögerung, insbesondere durch eine sprunghafte Erhöhung, erkennen lässt.

Damit ist die Aufgabe vollständig gelöst.

Bei einer bevorzugten Ausgestaltung der Erfindung sind die Änderung des zweiten Ausgangssignals und die Änderung des von der Verzögerungseinrichtung ausgegebenen ersten Ausgangssignals jeweils als Flanke ausgebildet.

Auf diese Weise können die verschiedenen Zustände gut unterschieden werden.

Bei einer weiteren bevorzugten Ausgestaltung sind die Signale an der Eingangsseite und an der Ausgangsseite als digitale Signale ausgebildet.

Dies ermöglicht eine besonders sichere Funktionsweise, da die Pegel für "0" bzw. "low" und "1" bzw. "high" mit deutlichem Pegelabstand zueinander gewählt werden können, so dass sich die Unterscheidung zwischen "0" und "1" auch mit einfachen Bauteilen schnell und sicher erfassen lässt.

Die vorgeschlagene Ausgestaltung ist, insbesondere in Verbindung von mindestens zwei Vorrichtungen zu einer Reihenschaltung, wie nachfolgend noch weiter erläutert wird, vorteilhaft, da über die Reihe der Vorrichtungen hinweg ausschließlich niederohmige digitale Signale vorhanden sind. Nur an lokal sehr begrenzten Orten, insbesondere den Verbindungen zwischen dem Sensorelement und einer Elektronik zur Realisierung der Vorrichtung, sind hochohmige Signale vorhanden.

Die Erfindung ermöglicht es, dass die Verbindungen besonders kurz gehalten werden können. Dadurch können störende Einflüsse schon vor der Verarbeitung des Ausgangssignals bzw. der Ausgangssignale minimiert werden, was der Signalqualität und Empfindlichkeit zugute kommt. Außerdem ergibt sich eine räumlich flexible Anordnung der einzelnen Vorrichtungen. Schließlich ist darauf hinzuweisen, dass diese Ausgestaltung den Einsatz eines nahezu beliebigen Mikrocontrollers erlaubt, da digitale Eingänge bei Mikrocontrollern regelmäßig vorhanden sind.

Bei einer weiteren bevorzugten Ausgestaltung der Erfindung ist das Zwischenelement als XOR-Element ausgebildet.

Das XOR-Element ermöglicht es auf einfache Weise, die Veränderung des zweiten Ausgangssignals zu bewirken, insbesondere die Invertierung des zweiten Ausgangssignals, wenn sich das erste Ausgangssignal ändert. Dadurch lässt sich die Funktionalität des zweiten Signalpfads kostengünstig realisieren.

Bei einer weiteren vorteilhaften Ausgestaltung der Erfindung weist die Verzögerungseinrichtung eine Grundverzögerung auf.

Unter dem Begriff der "Grundverzögerung" soll eine Verzögerung verstanden werden, die auch dann gegeben ist, wenn sich kein Objekt dem Sensorelement annähert. Mit anderen Worten ergibt sich für verschiedene Annäherungen keine Verzögerung, die geringer ist als die Grundverzögerung. Auf diese Weise kann sichergestellt werden, dass der erste Zeitpunkt, zu dem das erste Eingangssignal die Verzögerungseinrichtung erreicht, und der zweite Zeitpunkt, zu dem die Verzögerungseinrichtung das erste Ausgangssignal ausgibt, hinreichend genau bestimmt werden können.

Ferner ist es auf diese Weise möglich, die Empfindlichkeit des Sensorelements in erheblichen Grenzen zu variieren. Dabei ist es bevorzugt, wenn für eine empfindliche und weitreichende Annäherungsdetektion eine große Grundverzögerung gewählt wird und für eine weniger empfindliche Annäherungsdetektion geringer Reichweite eine kleine Grundverzögerung gewählt wird. Auch die Grundverzögerung wird in der oben genannten Größenordnung gewählt, d.h. bevorzugt zwischen 0,1 µs und 1 s, besonders bevorzugt zwischen 0,5 µs und 50 ms und insbesondere zwischen 1 µs und 1 ms.

Bei einer weiteren vorteilhaften Ausgestaltung der Erfindung ist die Verzögerungseinrichtung derart ausgebildet, dass die Verzögerung von einer Kapazität des Sensorelements bezogen auf ein festes Bezugspotential, insbesondere Erde oder Masse, abhängig ist.

Dadurch kann auf einfache Weise die Annäherung bzw. die Berührung eines Objekts mit kapazitivem Anteil erfasst werden, was insbesondere bei der Detektion eines menschlichen Fingers vorteilhaft ist. Bevorzugt stellt das Sensorelement die Kapazität oder einen Teil der Kapazität eines RC-Glieds dar. So erhält man eine zuverlässige Erfassung einer Annäherung bzw. einer Berührung, die dann gemäß der Erfindung in vorteilhafter Weise in eine Zeitdauer umgesetzt wird.

Bei einer weiteren bevorzugten Ausgestaltung der Erfindung ist das Sensorelement als Elektrode ausgeführt, die insbesondere durch ein Schirmungselement teilweise abgeschirmt ist.

Setzt man eine Elektrode als Sensorelement ein, so ergibt sich eine besonders kostengünstige Realisierung der Vorrichtung. Verwendet man ferner das genannte Schirmungselement, insbesondere als Schirmungsfläche ausgeführt, so kann die Feldausbreitung vor der Elektrode beeinflusst werden.

Soll der Empfindlichkeitsbereich der Elektrode vergrößert werden, so ist es vorteilhaft, wenn das Schirmungselement an das erste Eingangssignal gekoppelt wird. Werden zwei oder mehr Vorrichtungen verwendet, wie nachfolgend noch näher erläutert wird, lässt sich eine verringerte Trennschärfe zwischen benachbarten Sensorelementen bewirken. Soll hingegen die Empfindlichkeit verringert werden bzw. bei einer Verwendung von mindestens zwei Vorrichtungen die Trennschärfe zwischen benachbarten Sensorelementen erhöht werden, so ist es bevorzugt, in die Ankopplung des Schirmungselements an das erste Eingangssignal einen Inverter einzufügen. Auf diese Weise wird das Feld der Elektrode gedämpft.

Bei einer weiteren bevorzugten Ausgestaltung der Erfindung ist das Sensorelement von einem Abdeckelement überdeckt, das gegen das Sensorelement drückbar ist und bei Kontakt mit dem Sensorelement eine Änderung der Kapazität des Sensorelements bewirkt.

Diese Ausgestaltung ermöglicht es, neben der Erkennung einer Annäherung bzw. einer Berührung auch ein taktiles Gefühl einer mechanischen Taste zu vermitteln. Da bei der Entwicklung von Geräten die taktile Rückmeldung bei einer Eingabe an dem Gerät ein wichtiges Merkmal darstellt, kann durch diese Ausführungsform einer wichtigen Anforderung aus der Industrie Rechnung getragen werden. Das Abdeckelement ist dabei insbesondere als Schaltmatte, besonders bevorzugt aus Silikon, oder als so genannter Tact-Switch ausgebildet. Die Ausgestaltung einer derartigen Vorrichtung wird in den Ausführungsbeispielen noch näher erläutert.

Bei einer weiteren Ausgestaltung der Erfindung ist die Vorrichtung zusammen mit einer weiteren Vorrichtung, nachfolgend erste und zweite Vorrichtung genannt, zu einer Reihenschaltung verbunden, wobei die Ausgangseite der ersten Vorrichtung mit der Eingangsseite der zweiten Vorrichtung verbunden ist, und insbesondere der erste Ausgang der ersten Vorrichtung mit dem ersten Eingang der zweiten Vorrichtung und der zweite Ausgang der ersten Vorrichtung mit dem zweiten Eingang der zweiten Vorrichtung verbunden sind.

Bei dieser Ausgestaltung zeigt sich eine ganz besondere Eigenschaft der Vorrichtung, dass sich nämlich mehrere Vorrichtungen in Reihe verbinden lassen, ohne dass jede einzelne Vorrichtung getrennt gesteuert und ausgewertet werden muss. Dies wird dadurch ermöglicht, dass entlang der ersten Signalpfade ein Signal übertragen wird, das von jeder Vorrichtung verzögert wird, wohingegen das Signal entlang des zweiten Signalpfads nahezu unmittelbar auch am zweiten Ausgang der letzten Vorrichtung, hier der zweiten Vorrichtung, ausgelesen werden kann. Damit werden gewissermaßen die Verzögerungen der einzelnen Vorrichtungen nach und nach abgefragt, wobei sich jedes Ergebnis am zweiten Ausgang der letzten Vorrichtung ablesen lässt, ohne dass das Signal entlang des ersten Signalpfads ebenfalls bei der letzten Vorrichtung angekommen sein muss.

Das Zusammenspiel der Vorrichtungen, das sich mittels der Erfindung realisieren lässt, wird in den Ausführungsbeispielen noch ausführlich erläutert.

Bei einer vorteilhaften Ausgestaltung der Erfindung ist die Eingangsseite der ersten Vorrichtung mit einem Impulsgeber verbunden, dabei insbesondere sowohl mit dem ersten als auch mit dem zweiten Eingang der ersten Vorrichtung.

So kann auf einfache Weise das Signal erzeugt werden, mit dem die einzelnen Vorrichtungen der Reihenschaltung abgefragt werden können. Es sei darauf hingewiesen, dass es nicht erforderlich ist, dass sowohl der erste als auch der zweite Eingang physikalisch getrennt realisiert sind. Vielmehr ist es insbesondere ausreichend, dass das Eingangssignal des einen Signalpfads vom Eingangssignal des anderen Signalpfads abgezweigt wird. Dies wird auch in einem Ausführungsbeispiel später noch veranschaulicht.

Bei einer weiteren bevorzugten Ausgestaltung der Erfindung ist die Ausgangsseite eines letzten Elements der Reihenschaltung, insbesondere des zweiten Ausgangs, mit einer Auswerteeinheit verbunden.

Dies ermöglicht eine einfache und kostengünstige Überwachung aller Vorrichtungen in der Reihenschaltung. Aus den Änderungen am zweiten Ausgang des letzten Elements kann die Auswerteeinheit die einzelnen Verzögerungen der einzelnen Vorrichtungen ableiten.

Bei einer weiteren bevorzugten Ausgestaltung der Erfindung ist die Auswerteeinheit dafür ausgebildet, eine Zeit zwischen zwei Flanken im zweiten Ausgangssignal zu ermitteln und so die durch jede Verzögerungseinrichtung bewirkte Verzögerung zu bestimmen.

Dabei repräsentiert die Zeitdauer zwischen zwei Flanken im zweiten Ausgangssignal die Verzögerung einer Vorrichtung. Die erste Zeitdauer gibt die Verzögerung der ersten Vorrichtung, die zweite Zeitdauer die Verzögerung der zweiten Vorrichtung usw. an. Die Auswertung der Flanken ist insbesondere bei der digitalen Ausgestaltung der Vorrichtung vorteilhaft.

Bei einer weiteren vorteilhaften Ausgestaltung der Erfindung ist der erste Ausgang der zweiten Vorrichtung mit der Eingangsseite der ersten Vorrichtung zur Ausbildung eines Ringoszillators verbunden, wobei die Verbindung einen Inverter aufweist.

Bei Verwendung dieser Ausgestaltung lässt sich dann eine Frequenz auswerten, da die Zwischenfrequenzen, die am zweiten Ausgang entstehen, Informationen bezüglich der Annäherung eines Objekts an das Sensorelement geben.

Bei einer weiteren vorteilhaften Ausgestaltung der Erfindung werden nach dem Auswerten des zweiten Ausgangssignals am zweiten Ausgang das erste und das zweite Eingangssignal verändert, ein erneuter Durchgang von Senden, Verzögern, Verändern und Auswerten, wie zuvor beschrieben, durchgeführt, das resultierende zweite Ausgangssignal am zweiten Ausgang ausgewertet und ein Messwert unter Berücksichtigung der Auswertungen bei den ursprünglichen und bei den veränderten Eingangssignalen bestimmt.

Diese Ausgestaltung ermöglicht eine Differenzmessung, die zur Erhöhung der Messgenauigkeit herangezogen werden kann. Dabei wird das veränderte Eingangssignal insbesondere so ausgestaltet, dass sich die auf die Messung einwirkenden Störungen möglichst gegensätzlich auf das ursprüngliche Eingangssignal und auf das veränderte Eingangssignal auswirken. Dies bietet dann die Möglichkeit, die Störgrößen zu reduzieren und insbesondere sogar zu eliminieren.

Bei einer weiteren vorteilhaften Ausgestaltung der Erfindung ist das Verändern des ersten Eingangssignals als Invertieren des ersten Eingangssignals ausgestaltet.

Auf diese Weise ist es möglich, die Auswirkungen auf die Messung durch eine von außen eingebrachte Störfrequenz (z.B. eine Netzfrequenz) zu reduzieren oder sogar zu eliminieren. Wird beispielsweise die Annäherung an das Sensorelement über die Ladezeit eines RC-Glieds ermittelt, bei dem das Sensorelement einen Teil darstellt, so werden durch das ursprüngliche und das invertierte Eingangssignal eine Lade- und eine Entladezeit gemessen, die man gegeneinander verrechnen kann, um ein genaueres Messergebnis zu erhalten. Insbesondere ist es möglich, durch eine Mittelwertbildung zwischen Lade- und Entladezeit die Wirkung der Störfrequenz fast vollständig zu unterdrücken. Es lassen sich so genaue und schnelle Messungen durchführen, wobei man nicht mehr auf die Mittelung vieler einzelner Messungen angewiesen ist.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung näher dargestellt und werden in der nachfolgenden Beschreibung näher erläutert. Es zeigen:
- Fig. 1: ein erstes Ausführungsbeispiel einer Vorrichtung zum Erfassen einer Annäherung oder Berührung bezogen auf ein Sensorelement;
- Fig. 2: ein Ausführungsbeispiel eines Verfahrens zum Erfassen einer Annäherung oder Berührung bezogen auf ein Sensorelement;
- Fig. 3a: eine erste Ausführungsform einer Reihenschaltung von drei Vorrichtungen;
- Fig. 3b: eine zweite Ausführungsform einer Reihenschaltung von drei Vorrichtungen;
- Fig. 4a-4e: die Funktionsweise einer Reihenschaltung von drei Vorrichtungen, wobei sich bei zwei Sensorelementen zwei Gegenstände mit unterschiedlichen Abständen angenähert haben; und
- Fig. 5: ein zweites Ausführungsbeispiel einer Vorrichtung zum Erfassen einer Annäherung oder Berührung bezogen auf ein Sensorelement, die auch ein taktiles Druckgefühl ermöglicht.

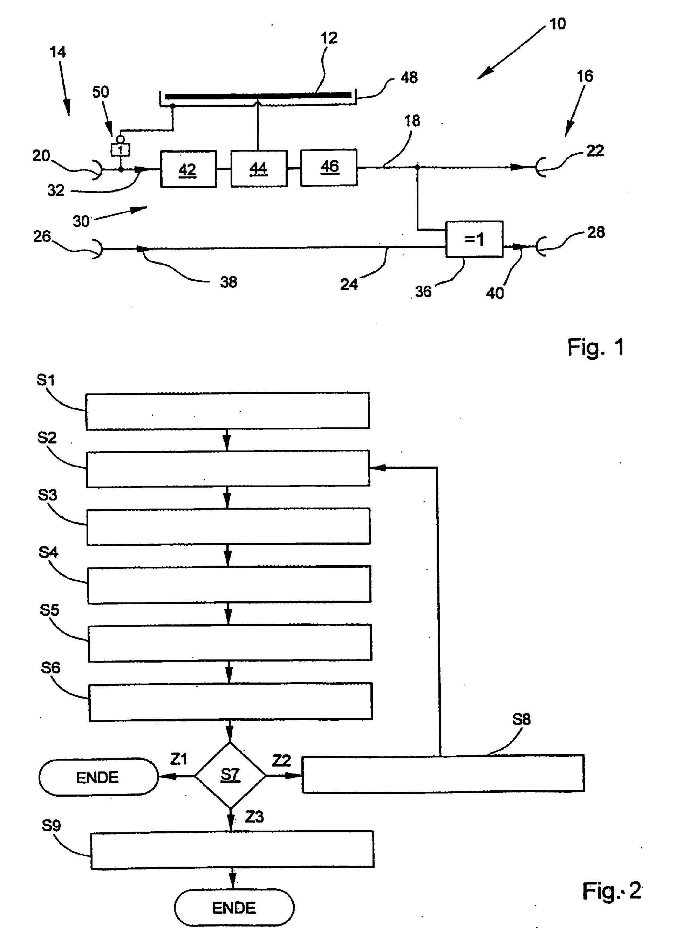

Fig. 1 zeigt eine Vorrichtung 10 zum Erfassen einer Annäherung oder Berührung bezogen auf mindestens ein Sensorelement 12, mit einer Eingangsseite 14 und einer Ausgangsseite 16, zwischen denen ein erster Signalpfad 18 mit einem ersten Eingang 20 und einem ersten Ausgang 22 und ein zweiter Signalpfad 24 mit einem zweiten Eingang 26 und einem zweiten Ausgang 28 angeordnet sind.

Der erste Signalpfad 18 weist eine Verzögerungseinrichtung 30 mit einer Verzögerung auf, die dafür ausgebildet ist, ein erstes Eingangssignal 32 am ersten Eingang 20 zu einem ersten Ausgangssignal 34 am zweiten Eingang 22 zu verzögern. Dabei ist die Verzögerung von der Annäherung oder Berührung bezogen auf das Sensorelement 12 abhängig. Der zweite Signalpfad 24 weist ein Zwischenelement 36 auf, um ein zweites Ausgangssignal 40 am zweiten Ausgang 28 zu ändern, wenn sich das von der Verzögerungseinrichtung 30 ausgegebene erste Ausgangssignal 34 ändert.

Die Vorrichtung 10 ist hier derart ausgebildet, dass die Signale 32, 34, 38, 40 an der Eingangsseite 14 und an der Ausgangsseite 16 als digitale Signale ausgebildet sind. In diesem Zusammenhang ist das Zwischenelement 36 als XOR-Element ausgebildet.

Bei diesem Ausführungsbeispiel weist die Verzögerungseinrichtung 30 drei Elemente auf, nämlich ein erstes Element 42, das eine vorgegebene Grundverzögerung bewirkt, ein zweites Element 44, das eine von der Annäherung oder Berührung bezogen auf das Sensorelement 12 abhängige Verzögerung bewirkt, und ein drittes Element 46, das ein vom zweiten Element 44 empfangenes Signal digitalisiert. Dabei handelt es sich bei dem dritten Element 46 bevorzugt um einen Schmitt-Trigger-Puffer. Es sei darauf hingewiesen, dass die Verzögerungseinrichtung 30 auf viele verschiedene Arten realisiert werden kann, wobei insbesondere die Funktionalität zweier oder sogar aller Elemente in einem Bauteil realisiert ist. Dies wäre insbesondere dann vorteilhaft, wenn das dritte Element 46 zum Digitalisieren bereits ein kapazitives Element mit einer Grundladezeit aufweist, die durch eine Annäherung an das Sensorelement 12 vergrößert werden kann. Dann kann die Verzögerungseinrichtung 30 besonders kostengünstig durch ein Bauteil realisiert werden.

Das Sensorelement 12 ist hier als Elektrode ausgeführt, die durch ein Schirmungselement 48 teilweise abgeschirmt ist. Die Abschirmung erfolgt hier, indem das Schirmungselement 48 über einen optionalen Inverter 50 mit dem ersten Eingang 20 verbunden ist.

Fig. 2 zeigt ein Ausführungsbeispiel eines Verfahrens zum Erfassen einer Annäherung oder Berührung bezogen auf mindestens ein Sensorelement 12, mit den folgenden Schritten:
- Bereitstellen (Schritt S1) einer Vorrichtung 10 mit einem ersten Eingang 20, einem ersten Ausgang 22, einem zweiten Eingang 26 und einem zweiten Ausgang 28,
- Anlegen (Schritt S2) eines ersten Eingangssignals 32 an den ersten Eingang 20,
- Anlegen (Schritt S3) eines zweiten Eingangssignals 38 an den zweiten Eingang 26, wobei sich am zweiten Ausgang 28 ein zweites Ausgangssignal 40 ergibt,
- Verzögern (Schritt S4) des ersten Eingangssignals 32 zu einem ersten Ausgangssignal 34, das zum ersten Ausgang 22 geführt wird, wobei die Verzögerung von der Annäherung oder Berührung bezogen auf das Sensorelement 12 abhängig ist,
- Verändern (Schritt S5) des zweiten Ausgangssignals 40, wenn sich das erste Ausgangssignal 34 ändert, und
- Auswerten (Schritt S6) des zweiten Ausgangssignals 40 am zweiten Ausgang 28.

Im einfachen Fall verzweigt das Verfahren (Schritt S7) über den Zweig Z1 zur Beendigung des Verfahrens. Für eine erweiterte Messung verzweigt das Verfahren über den Zweig Z2 zum Schritt S8, wo das erste und das zweite Eingangssignal 32, 38 verändert werden. Mit den veränderten Eingangssignalen 32, 38 werden dann erneut die Schritte des Sendens (Schritte S2, S3), des Verzögerns (Schritt S4), des Veränderns (Schritt S5) und des Auswertens (Schritt S6) durchgeführt. Das Verfahren verzweigt (Schritt S7) dann über den Zweig Z3 zum Schritt S9, wo ein Messwert unter Berücksichtigung der Auswertungen bei den ursprünglichen und bei den veränderten Eingangssignalen 32, 38 bestimmt wird. Danach wird das Verfahren beendet und kann erneut gestartet werden.

Es sei darauf hingewiesen, dass die Schritte S2 und S3 in unterschiedlicher Reihenfolge stattfinden können. Bevorzugt ist es auch möglich, dass der Schritt S3 deutlich vor dem Schritt S2 erfolgt, insbesondere wenn ein festes Potential, bevorzugt Masse oder Versorgungsspannung, als zweites Eingangssignal 38 verwendet werden soll, also an den zweiten Eingang 26 angelegt wird. Um in dieser Konstellation die Verzögerung durch die Verzögerungseinrichtung 30 zu bestimmen, kann man die Zeitdauer ermitteln, die vom Anlegen bzw. Senden des ersten Eingangssignals 32 bis zu der daraus resultierenden Reaktion am zweiten Ausgang 28 (und auch am ersten Ausgang 22 der entsprechenden Vorrichtung 10) vergeht.

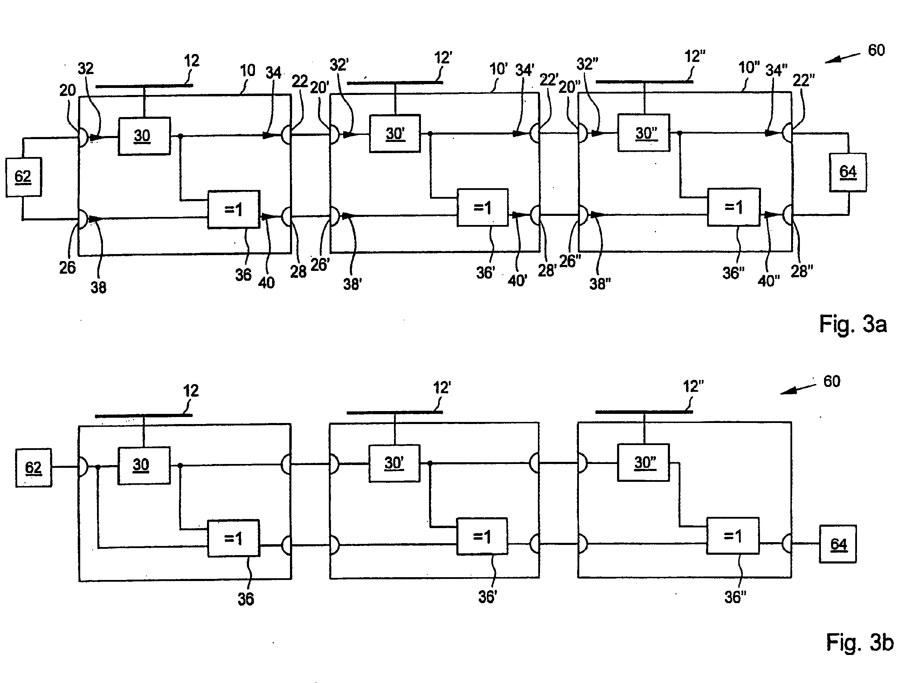

In den Fig. 3a und 3b ist jeweils eine Reihenschaltung 60 von drei Vorrichtungen 10, 10', 10" gezeigt. Betrachtet man durch Weglassen der mittleren Vorrichtung 10' lediglich die erste Vorrichtung 10 und die letzte Vorrichtung 10", so erkennt man anhand der nachfolgenden Erläuterungen auch die Funktionsweise für eine Reihenschaltung mit genau zwei Vorrichtungen 10, 10". In gleicher Weise kann die mittlere Vorrichtung 10' durch eine Vielzahl von in Reihe geschalteten Vorrichtungen ersetzt werden, so dass sich ebenso die Funktionsweise für eine Reihenschaltung von vier und mehr Vorrichtungen 10 ergibt. Damit können die Figuren als Erläuterung einer Reihenschaltung 60 mit beliebig vielen Vorrichtungen 10 verstanden werden.

Die Vorrichtungen 10, 10', 10" sind vereinfacht dargestellt: So ist die Verzögerungseinrichtung 30 nun durch ein Bauteil repräsentiert, und das Sensorelement 12 ist ungeschirmt.

In der Fig. 3a ist gezeigt, dass der erste Eingang 20 und der zweite Eingang 26 der ersten Vorrichtung 10 mit einem Impulsgeber 62 verbunden sind und dass der erste Ausgang 22 und der zweite Ausgang 28 der letzten Vorrichtung 10" mit einer Auswerteeinheit 64 verbunden sind.

Bei der Fig. 3b dagegen ist die erste Vorrichtung 10 an ihrem ersten Eingang 20 mit einem Impulsgeber 62 verbunden, und das zweite Eingangssignal 38 für den zweiten Signalpfad 24 wird vom ersten Signalpfad 18 abgezweigt. Ferner ist bei diesem Ausführungsbeispiel lediglich der zweite Ausgang 28 der letzten Vorrichtung 10" mit der Auswerteeinheit 64 verbunden, da dies für eine Realisierung der Erfindung ausreichend ist.

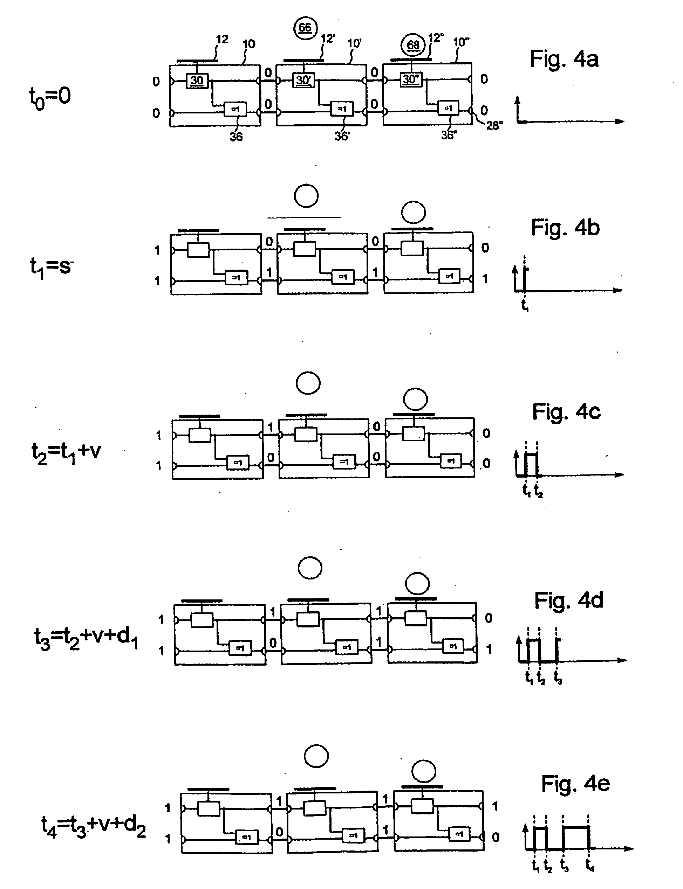

Anhand der Fig. 4a bis 4e wird nun die Funktionsweise der Reihenschaltung 60 erläutert. Es sei dabei angenommen, dass sich dem Sensorelement 12 der ersten Vorrichtung 10 kein Objekt annähert, sich bei der mittleren Vorrichtung 10' ein erstes Objekt 66 in einem größeren Abstand zum Sensorelement 12' befindet, und dass sich bei der letzten Vorrichtung 10" ein zweites Objekt 68 in einem kleineren Abstand zum Sensorelement 12" befindet.

In der Fig. 4a ist der Zustand zu einem Zeitpunkt to = 0 dargestellt. An den ersten und zweiten Eingängen 20, 26 der ersten Vorrichtung 10 liegen keine Signale an bzw. Signale, die eine digitale "0" repräsentieren. Es ist zu erkennen, dass damit an allen Ein- bzw. Ausgängen 20, 22, 26, 28, 20', 22', 26', 28', 20", 22", 26", 28" jeweils eine "0" anliegt. Wie dem kleinen Diagramm im rechten Teil der Fig. zu entnehmen ist, ist insbesondere der zweite Ausgang 28" der letzten Vorrichtung 10" auf "0". Das kleine Diagramm zeigt den zeitlichen Verlauf des Signals am zweiten Ausgang 28" der letzten Vorrichtung 10" an.

Zu einem Startzeitpunkt t₁ = s, in der Fig. 4b gezeigt, werden der erste und zweite Eingang 20, 26 der ersten Vorrichtung 10 mit einem Signal beaufschlagt, hier mit einer digitalen "1". Das erste Eingangssignal 32 entlang des ersten Signalpfads 18 wird von der Verzögerungseinrichtung 30 verzögert, so dass der erste Ausgang 22 der ersten Vorrichtung 10 zunächst unverändert auf "0" bleibt. Das zweite Eingangssignal 38 wird aber durch alle Zwischenelemente 36, 36', 36" hindurch zum zweiten Ausgang 28 der letzten Vorrichtung 10" geleitet. Damit ändert sich der Pegel am zweiten Ausgang 28" der letzten Vorrichtung 10" von "0" auf "1". Dies ist auch in dem Diagramm dargestellt.

Nachdem die Verzögerungseinrichtung 30 um einen Wert v verzögert hat, siehe Figur 4c, erscheint das Eingangssignal 32 als erstes Ausgangssignal 34 am ersten Ausgang 22 der ersten Vorrichtung 10. Bei dem Wert v handelt es sich um eine Grundverzögerung, so dass auch ohne die Annäherung eines Objekts an ein Sensorelement 12, 12', 12" stets mindestens die Grundverzögerung v entsteht. Sobald sich das erste Ausgangssignal 34 von "0" auf "1" ändert, wird über das Zwischenelement 36 auch das zweite Ausgangssignal 40 am zweiten Ausgang 28 der ersten Vorrichtung 10 verändert, d.h. von "1" auf "0". Diese Änderung setzt sich wiederum nahezu unmittelbar zum zweiten Ausgang 28" der letzten Vorrichtung 10" fort, so dass auch hier eine Signaländerung von "1" auf "0" erfasst werden kann, siehe Diagramm.

Das Signal "1" am ersten Eingang 20 der mittleren Vorrichtung 10' liegt jetzt an der Verzögerungseinrichtung 30' an und wird aufgrund der Verzögerung nicht unmittelbar an den ersten Ausgang 22' der mittleren Vorrichtung 10' weitergeleitet.

In der Fig. 4d ist der Zeitpunkt t₃ = t₂ + v + d₁ dargestellt, der sich einstellt, nachdem die Verzögerungseinrichtung 30' das Signal entlang des ersten Signalpfads 18' um den Wert v + d₁ verzögert hat. Dabei setzt sich die Verzögerung v + d₁ aus der Grundverzögerung v und einem Verzögerungswert d1 zusammen, der sich durch die Annäherung des ersten Objekts 66 an das Sensorelement 12' ergibt.

Sobald die Verzögerungseinrichtung 30' das erste Eingangssignal 32' an den ersten Ausgang 22' der mittleren Vorrichtung 10' weiterleitet, ändert sich auch der Zustand des zweiten Ausgangs 28' der mittleren Vorrichtung 10', nämlich von "0" auf "1". Diese Änderung ist unmittelbar am zweiten Ausgang 28" der letzten Vorrichtung 10" zu erkennen, siehe Diagramm.

Wie dem Diagramm zu entnehmen ist, ist die Zeitdauer von t₁ bis t₂ kleiner als die Zeitdauer von t₂ bis t₃. Demnach kann unterschieden werden, ob sich ein Objekt einem Sensorelement annähert. Da jede Flanke wieder als Trigger für den Beginn der nächsten Zeitdauer zu verstehen ist, d.h., dass z.B. die Flanke zum Zeitpunkt t₂ sowohl das Ende der Zeitdauer t₁ bis t₂, als auch den Anfang der Zeitdauer t₂ bis t₃ markiert, wird für jede Vorrichtung 10, 10', 10" immer wieder eine neue zeitliche Referenz bzw. ein neuer Startwert definiert, so dass die Messungen sehr genau durchgeführt werden können.

Schließlich wird in der Fig. 4e der Zustand zum Zeitpunkt t₄ = t₃ + v + d₂ gezeigt, bei dem die Verzögerungseinrichtung 10" das Signal entlang des ersten Signalpfads 18" um den Wert v + d₂ verzögert hat. Der Wert v + d₂ setzt sich hier aus der Grundverzögerung v und der durch die Annäherung des zweiten Objekts 68 an das Sensorelement 12" hervorgerufenen Verzögerung zusammen. Dem Diagramm ist zu entnehmen, dass die Verzögerung v + d₂ größer ist als die Verzögerung v + d_{1.}, woraus folgt, dass die Verzögerung d₂ größer ist als die Verzögerung d₁. Demnach lässt sich also erkennen, dass sich das zweite Objekt 68 weiter an das Sensorelement 12" angenähert hat, als das erste Objekt 66 an das Sensorelement 12'.

Da die Annäherung eines im Wesentlichen gleichen Objekts, insbesondere eines menschlichen Fingers, innerhalb eines Toleranzbereichs zu bestimmten Verzögerungen führt, kann aus einer gemessenen Zeitdauer bzw. aus einer gemessenen Verzögerung auch auf den Abstand eines Objekts zum Sensorelement geschlossen werden. Die für die Zuordnung von Verzögerung und Abstand benötigten Daten lassen sich rechnerisch und/oder empirisch ermitteln und insbesondere als Funktion oder als Tabelle/Kennfeld ablegen.

Auch wenn es bereits anhand der vorherigen Ausführungen deutlich geworden ist, sei ausdrücklich darauf hingewiesen, dass es die Erfindung ermöglicht, eine Vielzahl von Vorrichtungen 10 in Reihe zu schalten und diese lediglich mit einer Auswerteeinheit 64 auszuwerten. Ferner ist es möglich, innerhalb der Kette einen Fehler zu lokalisieren, denn wenn beispielsweise nur zwei Flanken detektiert werden, obwohl sich eigentlich vier Flanken zeigen müssten, so ist dies ein Hinweis darauf, dass die mittlere Vorrichtung 10' nicht funktionstüchtig ist.

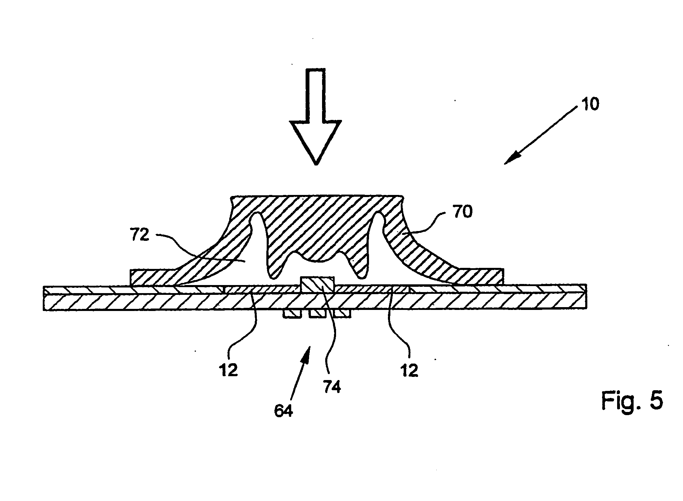

Fig. 5 zeigt ein zweites Ausführungsbeispiel einer Vorrichtung 10, bei der das Sensorelement 12 von einem Abdeckelement 70, hier einer Schaltmatte, überdeckt ist. Das Abdeckelement 70 ist elastisch und/oder flexibel und kann gegen das Sensorelement 12 gedrückt werden (symbolisiert durch den großen Pfeil). Die Auswerteeinheit 64 erkennt sowohl eine Annäherung an das Sensorelement 12 als auch eine Berührung des Sensorelements 12 durch das Abdeckelement 70. Das Abdeckelement 70 ist dabei derart ausgestaltet, dass sich eine Berührung des Sensorelements 12 durch das Abdeckelement 70, insbesondere durch eine deutliche Kapazitätsänderung, gut detektieren lässt.

Bei Verwendung von so genannten Tactswitches für die Erzeugung der haptischen Rückmeldung kann dieser Taster auch in die vorgestellte Lösung integriert werden. Hierbei wird einfach ein Kontakt des Tasters mit der Elektrode verbunden, der andere bleibt frei oder wird über einen hochohmigen Widerstand mit einem definierten Potential verbunden, insbesondere mit dem genannten Schirmungselement.

Damit tritt auch hier beim Schalten ein Sprung in der Kapazität der Elektrode auf, der von der Auswerteelektronik sehr sicher und einfach detektiert werden kann.

Damit kann die vorgestellte Lösung zu einem vergleichbaren Preis wie eine Schaltmatten- oder Tasterlösung hergestellt werden, bei gleichzeitiger Steigerung der Funktionalität durch alle bisher genannten Vorteile einer kapazitiven Annäherungsdetektion.

Zusätzlich zu den bisher genannten Punkten bietet die kapazitive Auswertung des Schaltereignisses die Möglichkeit, optische Elemente mit zu integrieren, da sich zwischen dem Sensorelement 12 und dem Abdeckelement 70 ein Hohlraum 72 realisieren lässt, in dem sich Licht verteilen kann. Das Abdeckelement 70 bzw. die Schaltmatte kann auch semitransparent oder milchig hergestellt werden. Damit bietet sie sich bei geeigneter mechanischer Ausführung gleichzeitig als diffuser Lichtleiter an. Es kann nun also auch ein Licht emittierendes Element innerhalb der Taste (Elektrode) eingesetzt werden, wie die in Fig. 5 dargestellte LED 74, die direkt unter der Schaltmatte und innerhalb der Elektrodenfläche angeordnet ist und die mechanische Taste von hinten anstrahlt. Diese Anordnung war gemäß dem Stand der Technik bisher nicht möglich.

## Patentansprüche

1. Vorrichtung (10) zum Erfassen einer Annäherung oder Berührung bezogen auf mindestens ein Sensorelement (12), mit einer Eingangsseite (14) und einer Ausgangsseite (16), zwischen denen ein erster Signalpfad (18) mit einem ersten Eingang (20) und einem ersten Ausgang (22), und ein zweiter Signalpfad (24) mit einem zweiten Eingang (26) und einem zweiten Ausgang (28) angeordnet sind, wobei der erste Signalpfad (18) eine Verzögerungseinrichtung (30) mit einer Verzögerung (v, d₁, d₂) aufweist, die dafür ausgebildet ist, ein erstes Eingangssignal (32) am ersten Eingang (20) zu einem ersten Ausgangssignal (34) am ersten Ausgang (22) zu verzögern, wobei die Verzögerung (v, d₁, d₂) von der Annäherung oder Berührung bezogen auf das Sensorelement (12) abhängig ist, und wobei der zweite Signalpfad (24) ein Zwischenelement (36) aufweist, das dafür ausgebildet ist, ein zweites Ausgangssignal (40) am zweiten Ausgang (28) zu ändern, wenn sich das von der Verzögerungseinrichtung (30) ausgegebene erste Ausgangssignal (34) ändert.

2. Vorrichtung nach Anspruch 1, wobei die Änderung des zweiten Ausgangssignals (40) und die Änderung des von der Verzögerungseinrichtung (30) ausgegebenen ersten Ausgangssignals (34) jeweils als Flanke ausgebildet sind.

3. Vorrichtung nach Anspruch 1 oder 2, wobei die Signale (32, 34, 38, 40) an der Eingangsseite (14) und an der Ausgangsseite (16) als digitale Signale ausgebildet sind.

4. Vorrichtung nach einem der vorhergehenden Ansprüche, wobei das Zwischenelement (36) als XOR-Element ausgebildet ist.

5. Vorrichtung nach einem der vorhergehenden Ansprüche, wobei die Verzögerungseinrichtung (30) eine Grundverzögerung (v) aufweist.

6. Vorrichtung nach einem der vorhergehenden Ansprüche, wobei die Verzögerungseinrichtung (30) derart ausgebildet ist, dass die Verzögerung (v, d₁, d₂) von einer Kapazität des Sensorelements (12) bezogen auf ein festes Bezugspotential, insbesondere Erde oder Masse, abhängig ist.

7. Reihenschaltung (60) mit mindestens einer ersten und einer zweiten Vorrichtung (10, 10') nach einem der Ansprüche 1 bis 6, wobei die Ausgangsseite (16) der ersten Vorrichtung (10) mit der Eingangsseite (14') der zweiten Vorrichtung (10') verbunden ist, insbesondere der erste Ausgang (22) der ersten Vorrichtung (10) mit dem ersten Eingang (20') der zweiten Vorrichtung (10') und der zweite Ausgang (28) der ersten Vorrichtung (10) mit dem zweiten Eingang (26') der zweiten Vorrichtung (10').

8. Reihenschaltung nach Anspruch 7, wobei die Eingangsseite (14) der ersten Vorrichtung (10) mit einem Impulsgeber (62) verbunden ist, insbesondere sowohl mit dem ersten als auch mit dem zweiten Eingang (20, 26) der ersten Vorrichtung (10).

9. Reihenschaltung nach Anspruch 7 oder 8, wobei die Ausgangsseite einer letzten Vorrichtung (10") der Reihenschaltung (60), insbesondere deren zweiter Ausgang (28"), mit einer Auswerteeinheit (64) verbunden ist.

10. Reihenschaltung nach einem der Ansprüche 7 bis 9, wobei die Auswerteeinheit (64) dafür ausgebildet ist, eine Zeit zwischen zwei Flanken im zweiten Ausgangssignal (40) zu ermitteln und so die durch jede Verzögerungseinrichtung (30, 30', 30") bewirkte Verzögerung (v, v+d₁, v+d₂) zu bestimmen.

11. Reihenschaltung nach einem der Ansprüche 7 bis 10, wobei der zweite Ausgang (22') der zweiten Vorrichtung (10') mit der Eingangsseite (14) der ersten Vorrichtung (10) zur Ausbildung eines Ringoszillators verbunden ist und die Verbindung einen Inverter aufweist.

12. Verfahren zum Erfassen einer Annäherung oder Berührung bezogen auf mindestens ein Sensorelement (12), mit den folgenden Schritten:
- Bereitstellen (S1) einer Vorrichtung (10) mit einer Eingangsseite (14), die einen ersten Eingang (20) und einen zweiten Eingang (26) aufweist, und mit einer Ausgangsseite (16), die einen ersten Ausgang (22) und einen zweiten Ausgang (28) aufweist,
- Anlegen (S2) eines ersten Eingangssignals (32) an den ersten Eingang (20),
- Anlegen (S3) eines zweiten Eingangssignals (38) an den zweiten Eingang (26), wobei sich am zweiten Ausgang (28) ein zweites Ausgangssignal (40) ergibt,
- Verzögern (S4) des ersten Eingangssignals (32) zu einem ersten Ausgangssignal (34), das zum ersten Ausgang (22) geführt wird, wobei die Verzögerung (v, d₁, d₂) von der Annäherung oder Berührung bezogen auf das Sensorelement (12) abhängig ist,
- Verändern (S5) des zweiten Ausgangssignals (40), wenn sich das erste Ausgangssignal (34) ändert, und
- Auswerten (S6) des zweiten Ausgangssignals (40) am zweiten Ausgang (28).

13. Verfahren nach Anspruch 12, ferner mit den folgenden Schritten:
- Nach dem Auswerten (S6) des zweiten Ausgangssignals (40) am zweiten Ausgang (28), Verändern (S8) des ersten Eingangssignals (32),
- Anlegen (S2, S3), Verzögern (S4), Verändern (S5) und Auswerten (S6) gemäß Anspruch 12, und
- Bestimmen (S9) eines Messwerts unter Berücksichtigung der Auswertungen bei den ursprünglichen und bei den veränderten Eingangssignalen (32, 38).

14. Verfahren nach Anspruch 13, wobei das Verändern (S8) des ersten Eingangssignals (32) als Invertieren des ersten Eingangssignals (32) ausgestaltet ist.

15. Verfahren nach einem der Ansprüche 12 bis 14, ferner mit den folgenden Schritten:
- Zusätzlich zur genannten, ersten Vorrichtung (10), Bereitstellen einer zweiten Vorrichtung (10') mit einem ersten Eingang (20'), einem ersten Ausgang (22'), einem zweiten Eingang (26') und einem zweiten Ausgang (28'),
- Weiterleiten des ersten Ausgangssignals (34) der ersten Vorrichtung (10) an den ersten Eingang (20') der zweiten Vorrichtung (10'),
- Weiterleiten des zweiten Ausgangssignals (40) der ersten Vorrichtung (10) an den zweiten Eingang (26') der zweiten Vorrichtung (10'), wobei sich am zweiten Ausgang (28') der zweiten Vorrichtung (10') ein zweites Ausgangssignal (40') ergibt,
- Verzögern des ersten Eingangssignals (32') der zweiten Vorrichtung (10') zu einem ersten Ausgangssignal (34') der zweiten Vorrichtung (10'), das zum ersten Ausgang (22') der zweiten Vorrichtung (10') geführt wird, wobei die Verzögerung (v, d₁, d₂) von der Annäherung oder Berührung bezogen auf ein zweites Sensorelement (12') abhängig ist, und
- Verändern des zweiten Ausgangssignals (40') der zweiten Vorrichtung (10'), wenn sich das erste Ausgangssignal (34') der zweiten Vorrichtung (10') ändert.

## Claims

1. Device (10) for detecting an approach or a touch related to at least one sensor element (12), the device comprising an input side (14) and an output side (16), between which a first signal path (18) with a first input (20) and a first output (22) and a second signal path (24) with a second input (26) and a second output (28) are arranged, wherein the first signal path (18) comprises a delay device (30) with a delay (v, d₁, d₂), the delay device (30) configured to delay a first input signal (32) at the first input (20) into a first output signal (34) at the first output (22), wherein the delay (v, d₁, d₂) is dependent on the approach or the touch related to the sensor element (12), and wherein the second signal path (24) comprises an intermediate element (36), which is configured to change a second output signal (40) at the second output (28), when the first output signal (34) outputted by the delay device (30) changes.

2. Device according to claim 1, wherein a change of the second output signal (40) and a change of the first output signal (34) outputted by the delay device (30) are each embodied as an edge.

3. Device according to claim 1 or 2, wherein signals (32, 34, 38, 40) at the input side (14) and the output side (16) are configured as digital signals.

4. Device according to any preceding claim, wherein the intermediate element (36) is configured as an XOR-element.

5. Device according to any preceding claim, wherein the delay device (30) comprises a basic delay (v).

6. Device according to any preceding claim, wherein the delay device (30) is configured such that the delay (v, d₁, d₂) depends on a capacity between the sensor element (12) and a fixed potential, preferably earth or ground.

7. Series arrangement (60) comprising at least a first and a second device (10, 10') according to any of claims 1 to 6, wherein an output side (16) of the first device (10) is connected to an input side (14') of the second device (10'), preferably the first output (22) of the first device (10) with the first input (20') of the second device (10') and the second output (28) of the first device (10) with the second input (26') of the second device (10').

8. Series arrangement according to claim 7, wherein an input side (14) of the first device (10) is connected to a pulse generator (62), preferably with the first and the second input (20, 26) of the first device (10).

9. Series arrangement according to claim 7 or 8, wherein an output side of a last device (10") in the series arrangement (60), preferably its second output (28"), is connected to an evaluation device (64).

10. Series arrangement according to any of claims 7 to 9, wherein the evaluation device (64) is configured to detect a time interval between two edges in the second output signal (40) in order to determine each delay (v, v+d₁, v+d₂) caused by each of the delay devices (30, 30', 30").

11. Series arrangement according to any of claims 7 to 10, wherein a second output (22') of the second device (10') is connected with an input side (14) of the first device (10) in order to create a ring oscillator, wherein the connection comprises an inverter.

12. Method for detecting an approach or a touch related to at least one sensor element (12), the method comprising the following steps:
- providing (S1) a device (10) with an input side (14) comprising a first input (20) and a second input (26), and an output side (16) comprising a first output (22) and a second output (28),
- applying (S2) a first input signal (32) to the first input (20),
- applying (S3) a second input signal (38) to the second input (26), resulting in a second output signal (40) at the second output (28),
- delaying (S4) the first input signal (32) into a first output signal (34), which is fed to the first output (22), wherein the delay (v, d₁, d₂) depends on the approach or the touch related to the sensor element (12),
- changing (S5) the second output signal (40), when the first output signal (34) changes, and
- evaluating (S6) the second output signal (40) at the second output (28).

13. Method according to claim 12 further comprising the following steps:
- after the step of evaluating (S6) the second output signal (40) at the second output (28), modifying (S8) the first input signal (32),
- applying (S2, S3), delaying (S4), changing (S5) and evaluating (S6) according to claim 12, and
- determining (S9) a measurement value in consideration of evaluation results based on the original and the modified first input signals (32, 38).

14. Method according to claim 13 wherein the step of modifying (S8) the first input signal (32) comprises inverting the first input signal (32).

15. Method according to any of claims 12 to 14 further comprising the following steps:
- in addition to the first device (10), providing a second device (10') with a first input (20'), a first output (22'), a second input (26') and a second output (28'),
- feeding the first output signal (34) of the first device (10) to the first input (20') of the second device (10'),
- feeding the second output signal (40) of the first device (10) to the second input (26') of the second device (10'), resulting in a second output signal (40') at the second output (28') of the second device (10'),
- delaying the first input signal (32') of the second device (10') into a first output signal (34') of the second device (10'), which is fed to the first output (22') of the second device (10'), wherein the delay (v, d₁, d₂) depends on an approach or a touch related to a second sensor element (12'), and
- changing the second output signal (40') of the second device (10'), when the first output signal (34') of the second device (10') changes.

## Revendications

1. Dispositif (10) destiné à détecter une proximité ou un contact par rapport à au moins un élément capteur (12), comprenant un côté d'entrée (14) et un côté de sortie (16) entre lesquels sont disposés un premier trajet de signal (18) comportant une première entrée (20) et une première sortie (22), et un second trajet de signal (24) comportant une seconde entrée (26) et une seconde sortie (28), dans lequel le premier trajet de signal (18) comprend un moyen à retard (30) générant un retard (v, d₁, d₂), qui est conçu pour retarder un premier signal d'entrée (32) sur la première entrée (20) en un premier signal de sortie (34) sur la première sortie (22), dans lequel le retard (v, d₁, d₂) dépend de la proximité ou du contact par rapport à l'élément capteur (12), et dans lequel le second trajet de signal (24) comprend un élément intermédiaire (36) qui est conçu pour transformer un second signal de sortie (40) sur la seconde sortie (28) lorsque le premier signal de sortie (34) délivré par le moyen à retard (30) varie.

2. Dispositif selon la revendication 1, dans lequel la modification du second signal de sortie (40) et la modification du premier signal de sortie (34) délivré par le moyen à retard (30) se présentent respectivement sous la forme de fronts.

3. Dispositif selon la revendication 1 ou 2, dans lequel les signaux (32, 34, 38, 40) présents sur le côté d'entrée (14) et sur le côté de sortie (16) se présentent sous la forme de signaux numériques.

4. Dispositif selon l'une quelconque des revendications précédentes, dans lequel l'élément intermédiaire (36) est réalisé sous la forme d'un élément OU-EXCLUSIF.

5. Dispositif selon l'une quelconque des revendications précédentes, dans lequel le moyen à retard (30) présente un retard de base (v).

6. Dispositif selon l'une quelconque des revendications précédentes, dans lequel le moyen à retard (30) est réalisé de telle sorte que le retard (v, dl, dz) dépende d'une capacité de l'élément capteur (12) par rapport à un potentiel de référence fixe, notamment la terre ou la masse.

7. Circuit série (60) comprenant au moins un premier et un second dispositifs (10, 10') selon l'une quelconque des revendications 1 à 6, dans lequel le côté de sortie (16) du premier dispositif (10) est connecté au côté d'entrée (14') du second dispositif (10'), la première sortie (22) du premier dispositif (10) étant plus particulièrement connectée à la première entrée (20') du second dispositif (10') et la seconde sortie (28) du premier dispositif (10) étant plus particulièrement connectée à la seconde entrée (26') du second dispositif (10').

8. Circuit série selon la revendication 7, dans lequel le côté d'entrée (14) du premier dispositif (10) est connecté à un générateur d'impulsions (62), et est plus particulièrement connecté à la fois aux première et seconde entrées (20, 26) du premier dispositif (10).

9. Circuit série selon la revendication 7 ou 8, dans lequel le côté de sortie d'un dernier dispositif (10") du circuit série (60), notamment sa seconde sortie (28"), est connecté à une unité d'évaluation (64).

10. Circuit série selon l'une quelconque des revendications 7 à 9, dans lequel l'unité d'évaluation (64) est réalisée de manière à obtenir un temps compris entre deux fronts du second signal de sortie (40) et par conséquent, à déterminer le retard (v, v+d₁, v+d₂) généré par chaque moyen à retard (30, 30', 30").

11. Circuit série selon l'une quelconque des revendications 7 à 10, dans lequel la seconde sortie (22') du second dispositif (10') est connectée au côté d'entrée (14) du premier dispositif (10) pour former un oscillateur en anneau et dans lequel la connexion comprend un inverseur.

12. Procédé destiné à détecter une proximité ou un contact par rapport à au moins un élément capteur (12), comprenant les étapes consistant à :
- fournir (S1) un dispositif (10) comprenant un côté d'entrée (14) comportant une première entrée (20) et une seconde entrée (26), et comprenant un côté de sortie (16) comportant une première sortie (22) et une seconde sortie (28),
- appliquer (S2) un premier signal d'entrée (32) à la première entrée (20),
- appliquer (S3) un second signal d'entrée (38) à la seconde entrée (26), un second signal de sortie (40) apparaissant sur la seconde sortie (28),
- retarder (S4) le premier signal d'entrée (32) en un premier signal de sortie (34) qui est acheminé à la première sortie (22), le retard (v, d₁, d₂) dépendant de la proximité ou du contact par rapport à l'élément capteur (12),
- modifier (S5) le second signal de sortie (40) lorsque le premier signal de sortie (34) varie, et
- évaluer (S6) le second signal de sortie (40) sur la seconde sortie (28).

13. Procédé selon la revendication 12, comprenant en outre les étapes consistant à :
- après l'évaluation (S6) du second signal de sortie (40) sur la seconde sortie (28), modifier (S8) le premier signal d'entrée (32),
- appliquer (S2, S3), retarder (S4), modifier (S5) et évaluer (S6) selon la revendication 12, et
- déterminer (S9) une valeur de mesure en tenant compte des évaluations correspondant aux signaux d'entrée modifiés (32, 38).

14. Procédé selon la revendication 13, dans lequel la modification (S8) du premier signal d'entrée (32) est réalisée sous la forme d'une inversion du premier signal d'entrée (32).

15. Procédé selon l'une quelconque des revendications 12 à 14, comprenant en outre les étapes consistant à :
- en plus dudit premier dispositif (10), fournir un second dispositif (10') comportant une première entrée (20'), une première sortie (22'), une seconde entrée (26') et une seconde sortie (28'),
- acheminer le premier signal de sortie (34) du premier dispositif (10) à la première entrée (20') du second dispositif (10'),
- acheminer le second signal de sortie (40) du premier dispositif (10) à la seconde entrée (26') du second dispositif (10'), un second signal de sortie (40') apparaissant sur la seconde sortie (28') du second dispositif (10'),
- retarder le signal d'entrée (32') du second dispositif (10') en un premier signal de sortie (34') du second dispositif (10'), qui est dirigé vers la première sortie (22') du second dispositif (10'), dans lequel le retard (v, d₁, d₂) dépend de la proximité ou du contact par rapport à un second élément capteur (12'), et
- modifier le second signal de sortie (40') du second dispositif (10') lorsque le premier signal de sortie (34') du second dispositif (10') varie.
